# EUROPEAN PATENT APPLICATION

(11) **EP 4 087 131 A1**
(43) Date of publication of application: **09.11.2022**
(21) Application number: 20910346.4
(22) Date of filing: 06.05.2020
(51) Int. Cl.: H03H 9/15, H03H 9/13

(54) **BULK ACOUSTIC WAVE RESONATOR HAVING ELECTRICAL ISOLATION LAYER AND MANUFACTURING METHOD THEREFOR, FILTER, AND ELECTRONIC DEVICE**

(30) Priority: 31.12.2019 CN 201911419042
(71) Applicant: Rofs Microsystem (Tianjin) Co., Ltd, Tianjin 300462 (CN)
(72) Inventor: PANG, Wei, Tianjin 300072 (CN); YANG, Qingrui, Tianjin 300072 (CN); ZHANG, Menglun, Tianjin 300072 (CN)
(74) Representative: Ström & Gulliksson AB
(86) International application number: PCT/CN2020/088763
(87) International publication number: WO 2021/135022

(57) **Abstract**

Disclosed in the present disclosure is a bulk acoustic wave resonator, including: a substrate; a bottom electrode; a top electrode; a piezoelectric layer arranged between the bottom electrode and the top electrode; and an acoustic mirror. The resonator further includes an electrode connecting part, an electrical isolation layer, and an electrode pin; the electrode connecting part covers the electrical isolation layer, one end of the electrode connecting part is electrically connected to the top electrode, and the other end of the electrode connecting part is adapted to be electrically connected to the electrode pin; one part of the electrical isolation layer forms electrical isolation between the electrode connecting part of the resonator and the bottom electrode; at least one part of the electrical isolation layer covers at least one part of the end surface of the piezoelectric layer and the end surface of the bottom electrode so as to form electrical isolation between the electrode connecting part and the bottom electrode. Also disclosed in the present disclosure are a manufacturing method for the bulk acoustic wave resonator, a filter having the resonator, and an electronic device having the filter or the resonator.

## Description

### TECHNICAL FIELD

The present disclosure relates to the field of semiconductors, and in particular, to a bulk acoustic wave resonator, a filter, an electronic device including the resonator or the filter, and a manufacturing method of the bulk acoustic wave resonator.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small size, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

In a traditional bulk acoustic wave resonator, a bottom-up processing method is used, and a crucial step of this method is to pattern a bottom electrode after sputtering the bottom electrode and then grows a piezoelectric layer. Accordingly, breakage or crystal orientation change of the piezoelectric layer is prone to occur at an edge of the electrode, which results in a decreased electromechanical coupling coefficient.

In addition, in a monocrystal bulk acoustic wave resonator, it is impossible to directly grow monocrystal materials on the patterned bottom electrode since the monocrystal growth has extremely high requirements on interface materials, interface crystallinity, interface cleanliness, roughness, and flatness. Hence, a back etching method is generally used to deposit the bottom electrode, which increases the process difficulty and the complexity of package for the wafer-level devices due to requirement of front side package and back side package.

### SUMMARY

In order to solve or alleviate at least one aspect of technical problems in the related art, the present disclosure is provided.

According to an aspect of embodiments of the present disclosure, there is provided a bulk acoustic wave resonator, which includes a substrate, a bottom electrode, a top electrode, a piezoelectric layer, and an acoustic mirror. The piezoelectric layer is arranged between the bottom electrode and the top electrode. The resonator further includes an electrode connection portion, an electrical isolation layer, and an electrode pin. The electrode connection portion covers the electrical isolation layer, one end of the electrode connection portion is electrically connected to the top electrode, and another end of the electrode connection portion is configured to be electrically connected to the electrode pin. A part of the electrical isolation layer forms electrical isolation between the electrode connection portion and the bottom electrode of the resonator. At least one portion of the electrical isolation layer covers at least part of an end face of the piezoelectric layer and an end face of the bottom electrode to form electrical isolation between the electrode connection portion and the bottom electrode.

An embodiment of the present disclosure also relates to a method of manufacturing a bulk acoustic wave resonator. The bulk acoustic wave resonator includes a substrate, a bottom electrode, a top electrode, a piezoelectric layer provided between the bottom electrode and the top electrode, and an acoustic mirror. The method includes: providing a bottom electrode layer covering the substrate and a piezoelectric film layer covering the bottom electrode on the substrate; patterning the bottom electrode and the piezoelectric layer, that is, etching and patterning the bottom electrode layer and the piezoelectric film layer, to form the bottom electrode and the piezoelectric layer of the resonator; providing an electrical isolation layer, the electrical isolation layer covering at least part of an end face of the piezoelectric layer and an end face of the bottom electrode; and depositing a conductive metal layer, the conductive metal layer covering the electrical isolation layer and a part of a top surface of the piezoelectric layer to form the top electrode and an electrode connecting portion, the electrode connection portion being electrically connected to the top electrode, and the electrical isolation layer providing an electrical isolation space between the electrode connection portion and the bottom electrode.

An embodiment of the present disclosure also relates to a filter including the above bulk acoustic wave resonator.

An embodiment of the present disclosure also relates to an electronic device including the filter or resonator as described above.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1A is a schematic sectional view of a bulk acoustic wave resonator according to an exemplary embodiment of the present disclosure;
FIG. 2 is a schematic sectional view of a bulk acoustic wave resonator according to another exemplary embodiment of the present disclosure;
FIG. 3 is a schematic sectional view of a bulk acoustic wave resonator according to yet another exemplary embodiment of the present disclosure;

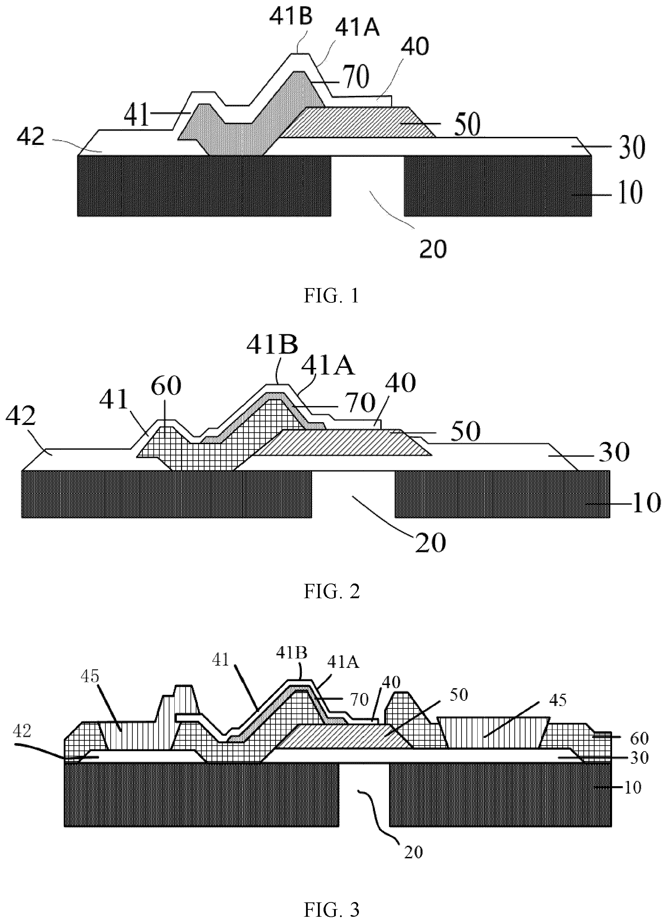

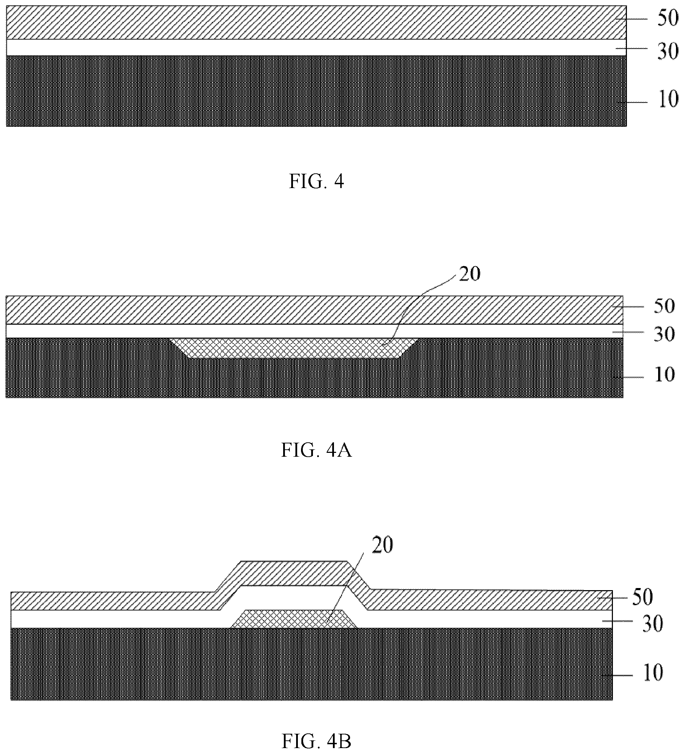

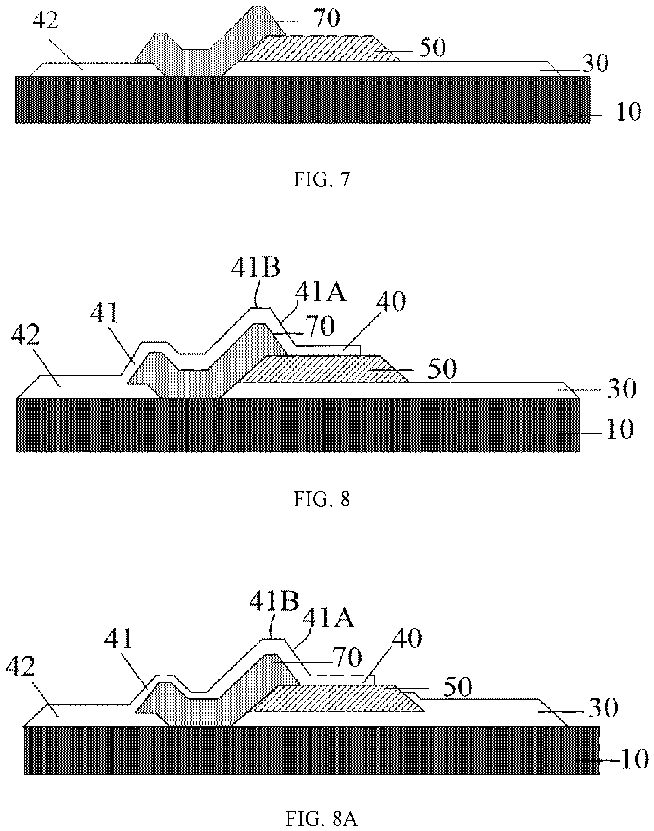

FIGS. 4 to 8 are process diagrams exemplarily illustrating a method of manufacturing the bulk acoustic wave resonator in FIG. 1 according to an exemplary embodiment of the present disclosure, in which FIG. 4A shows an additional exemplary sectional view in which a bottom electrode layer and a piezoelectric film layer are provided on a substrate having an acoustic mirror cavity to be released as an alternative embodiment of the structure shown in FIG. 4; FIG. 4B is an additional exemplary sectional view showing a bottom electrode layer and a piezoelectric film layer provided on a substrate having an acoustic mirror cavity that is to be released and arranged on an upper surface of the substrate, as another alternative embodiment of the structure shown in FIG. 4; and FIG. 8A shows a schematic sectional diagram of a structure formed by depositing a conductive metal on an electrode connection portion of a bottom electrode when providing a top electrode and the electrode connection layer, as an alternative embodiment of the structure shown in FIG. 8;
FIGS. 9 to 11 are process diagrams exemplarily illustrating a method of manufacturing the bulk acoustic wave resonator in FIG. 2 according to an exemplary embodiment of the present disclosure, in which FIG. 11A shows a schematic sectional diagram of a structure formed by depositing a conductive metal on an electrode connection portion of a bottom electrode when providing a top electrode and the electrode connection layer, as an alternative embodiment of the structure shown in FIG. 11; and
FIGS. 12 to 13 are process diagrams illustrating a method of manufacturing the bulk acoustic wave resonator in FIG. 3 according to an exemplary embodiment of the present disclosure.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

In the present disclosure, a top-down processing method is used. A piezoelectric layer is directly grown after a bottom electrode is grown, or a bulk acoustic wave resonator is formed on a monocrystal piezoelectric layer provided with a bottom electrode through other methods (such as bonding), and a top electrode is extracted by adding an air or dielectric isolation layer. In the present disclosure, a parasitic capacitance between the top electrode and the bottom electrode in a non-resonant region is minimized, thereby ensuring that an electromechanical coupling coefficient of the resonator cannot be reduced. The manufacturing method of the present disclosure adopts conventional processing steps, and has advantages of simple operation, easy large-scale manufacturing, and high device stability.

In the present disclosure, reference numbers are as follows.

10: Substrate, which is generally made of a material such as monocrystalline silicon, gallium arsenide, sapphire, quartz, lithium niobate, and silicon carbide.

20: Acoustic mirror, which is an air cavity in this example, and may adopt a Bragg reflection layer or other equivalent acoustic reflection structures. The cavity may be a through hole formed by back etching, a cavity structure formed in the substrate, or an air gap structure formed above the substrate.

30/40: Bottom electrode/top electrode, which may be made of gold (Au), tungsten (W), molybdenum (Mo), platinum (Pt), ruthenium (Ru), iridium (Ir), titanium tungsten (TiW), aluminum (Al), titanium (Ti), or composites or alloys thereof. The two layers of the bottom and top electrodes is generally made of a same material, but may be made of different materials.

45: Conductive through hole, which may be made of the above metal materials.

41: Electrode connection portion, which is made of a material same as that of the top electrode.

42: Electrode pin, which is made of a material same as that of the bottom electrode.

50: Piezoelectric thin film or a piezoelectric layer, which may be made of a material such as polycrystalline or monocrystal AlN, rare earth element doped AlN, lead zirconate titanate (PZT), zinc oxide (ZnO), monocrystal lithium niobate (LiNbO₃), potassium niobate (KNbO₃), or lithium tantalate (LiTa03), but the material is not limited to the above materials.

60: Dielectric layer, which may be made of a material such as AlN, rare earth element doped AlN, silicon nitride, and silicon dioxide.

70: Dielectric layer or air gap, in which a dielectric material may be made of a material such as AlN, rare earth element doped AlN, silicon nitride, and silicon dioxide.

In the present disclosure, the bottom electrode, the piezoelectric layer, the top electrode and the acoustic mirror overlap with each other in a thickness direction of the resonator to form an overlapping region, which is an effective region of the resonator.

FIG. 1A is a schematic sectional view of a bulk acoustic wave resonator according to an exemplary embodiment of the present disclosure. In a structure shown in FIG. 1, the electrical isolation layer 70 is a non-conductive dielectric monolayer, which may be a gap layer or a non-conductive solid dielectric layer.

FIG. 2 is a schematic sectional view of a bulk acoustic wave resonator according to another exemplary embodiment of the present disclosure. In FIG. 2, an air gap is indicated by 70 and a dielectric layer is indicated by 60. The isolation degree between the top electrode and the bottom electrode is improved by locally introducing the air gap 70 near the effective region of the resonator, and a suspending span of the top electrode is reduced by providing the dielectric layer 60, thereby improving the structural stability.

In FIG. 2, the electrical isolation layer includes two layers, namely, the layer 70 and the non-conductive solid dielectric layer 60. The layer 70 is releasable by etching, and is the gap layer after being released. The layer 70 may not be released such that the electrical isolation layer is an isolation layer including two non-conductive solid dielectric layers. As shown in FIG. 2, the gap layer 70 covers a part of a top surface of the piezoelectric layer 50, while the dielectric layer 60 also covers a part of the top surface of the piezoelectric layer 50. In FIG. 2, a right end of the gap layer 70 is located at an inner side of a right end of the dielectric layer 60 or closer to a center of the resonator. However, a positional relationship between the layer 70 and the layer 60 is not limited to this.

FIG. 3 is a schematic sectional view of a bulk acoustic wave resonator according to yet another exemplary embodiment of the present disclosure. In FIG. 3, the isolation layer is deposited not only under the top electrode, but also in a region beyond the region shown in FIG. 2. For example, the isolation layer may cover the electrode pin or the electrode connection portion of the bottom electrode. In other words, in the structure shown in FIG. 3, the electrical isolation layer covers the electrode pin and/or a part of the bottom electrode of the resonator outside the effective region, except for the covered region as shown in FIGS. 1 and 2. The resonator also includes at least one conductive through hole 45, which passes through an additional electrical isolation layer to be electrically connected to a corresponding electrode pin or the bottom electrode. The electrode connection portion 41 is electrically connected to the electrode pin 42 through the electrical through hole 45 passing through the additional electrical isolation layer in a case where the additional electrical isolation layer covers the electrode pin.

Based on the structures of FIGS. 1 to 3, the electrode connection portion 41 covers the electrical isolation layers 60, 70. One end of the electrode connection portion 41 is electrically connected to the top electrode 40, and the other end of the electrode connecting portion 41 is configured to be electrically connected to the electrode pin 42. A part of the electrical isolation layers forms electrical isolation between the electrode connection portion 41 and the bottom electrode 30 of the resonator.

As mentioned in a following manufacturing method, the electrode connection layer 41 and the top electrode 40 are deposited simultaneously in a same layer, so that the electrode connection portion has a same thickness as the top electrode.

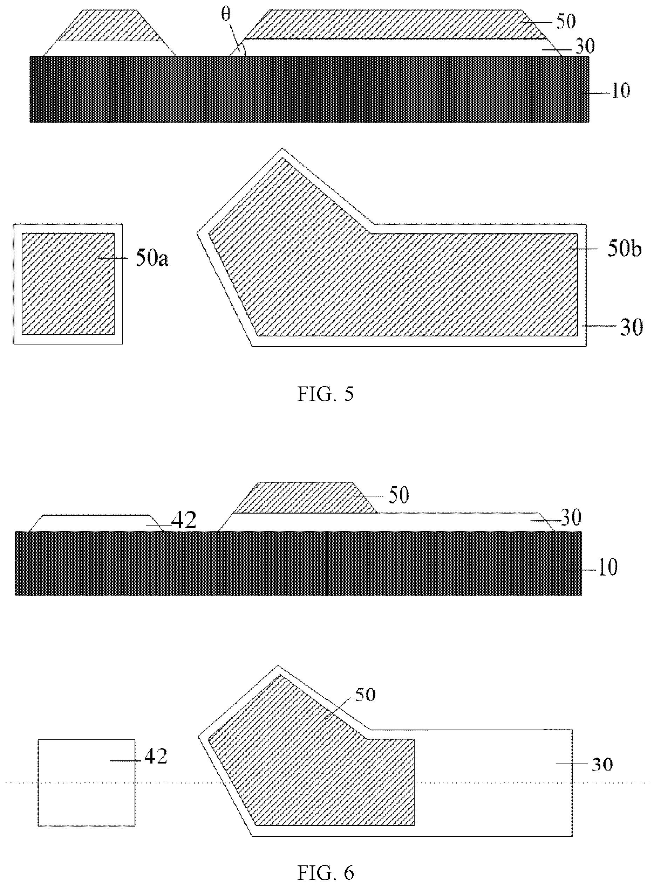

As shown in FIGS. 1 to 3, an end face of the piezoelectric layer 50 and an end face of the bottom electrode 30 form a coplanar inclined surface. An angle is formed between the inclined surface and a top surface of the substrate (for example, θ in FIG. 5), and is in a range of 10 to 85 degrees. Further, the angle may be in a range of 15 to 75 degrees.

For example, referring to FIGS. 1 and 2, at least part of the electrical isolation layers 60, 70 covers the end face of the piezoelectric layer 50 and an end face of the electrode pin 42, and also covers a part of the top surface of the piezoelectric layer 50. Further, the electrical isolation layers 60, 70 cover one end of the piezoelectric layer 50 and falls within a region of the acoustic mirror. In addition, as shown in FIG. 1, the electrode connection portion 41 includes an inclined section 41A connected with the top electrode 40 and a horizontal section 41B connected with the inclined section.

As shown in FIGS. 1 to 3, at least part of the electrical isolation layers 60, 70 forms electrical isolation between the electrode pin 42 and the bottom electrode 30 in a lateral direction of the resonator.

As shown in FIGS. 1 to 3, the electrode pin 42 is arranged in the same layer as the bottom electrode 30, and a space of the same layer between the electrode pin 42 and the bottom electrode 30 in the lateral direction is filled by a portion of the electrical isolation layers 60, 70.

As shown in FIGS. 1 to 3, the electrical isolation layers 60, 70 cover a part of the top surface of the piezoelectric layer 50, and the electrical isolation layer covers a part of a top surface of the electrode pin 42. A portion of the electrical isolation layers 60, 70 arranged between the electrode pin 42 and the bottom electrode 30 has a concave shape relative to a portion of the electrical isolation layer covering the top surface of the top electrode and the top surface of the electrode pin.

For example, referring to FIG. 1, the electrical isolation layer 70 is arranged between the electrode connection portion 41 and the electrode pin 42 in the thickness direction of the resonator on a left side in FIG. 1.

A method of manufacturing the structures shown in FIGS. 1 to 3 is exemplarily described below with reference to FIGS. 4 to 12.

FIGS. 4 to 8 are process diagrams illustrating a method of manufacturing the bulk acoustic wave resonator in FIG. 1 according to an exemplary embodiment of the present disclosure.

Firstly, a substrate 10 as shown in FIG. 4 is obtained, and is provided with a complete bottom electrode 30 and a complete piezoelectric layer 50 thereon. The structure for forming the complete bottom electrode 30 and the complete piezoelectric layer 50 on the substrate 10 is not limited to that shown in FIG. 4. FIG. 4A shows an additional exemplary sectional view in which a bottom electrode layer and a piezoelectric film layer are provided on a substrate having an acoustic mirror cavity to be released as an alternative embodiment of the structure shown in FIG. 4. For example, the substrate of FIG. 4A can be obtained, a cavity 20 filled with a sacrificial layer has been pre-embedded in the substrate, and the complete bottom electrode 30 and a piezoelectric layer 50 are simultaneously formed. Alternatively, as shown in FIG. 4B, a protruding sacrificial layer is formed on a surface of the substrate 10 in advance to finally form the cavity 20, and the complete bottom electrode 30 and the piezoelectric layer 50 are simultaneously provided.

Thereafter, a description will be provided based on the structure shown in FIG. 4 or based on the structures shown in FIGS. 4A and 4B.

A bottom electrode pattern is formed simultaneously on the piezoelectric layer and the bottom electrode through photolithography and etching techniques, and a sectional view of the bottom electrode pattern is illustrated in FIG. 5. An upper diagram of FIG. 5 is a schematic sectional diagram showing a process of the method of manufacturing the bulk acoustic wave resonator in FIG. 1, and a lower diagram of FIG. 5 is a top view of the upper diagram. In the top view of FIG. 5, a bottom electrode portion and a piezoelectric layer material portion (corresponding to 50a in FIG. 5) are separated from the resonator, and the piezoelectric layer (corresponding to 50b in FIG. 5) and the bottom electrode 30 for forming a main region of the resonator are shown. In order to ensure that the isolation layer can completely cover side walls of the bottom electrode and piezoelectric layer, side surfaces of the piezoelectric layer and electrode layer are etched to each have an inclination angle θ, which ranges from 10 degrees to 85 degrees, and further from 15 degrees to 75 degrees.

The piezoelectric layer is selectively etched by a process such as photolithography and etching to expose a top electrode pin 42 and a bottom electrode pin, and a sectional view and a top view thereof are illustrated in FIG. 6.

Based on FIG. 6, steps of manufacturing the structure of the resonator shown in FIG. 1 are described below.

A dielectric layer or sacrificial layer 70 is deposited between the electrode pin 42 and the piezoelectric layer 50, as shown in FIG. 7.

Thereafter, a metal layer (including the top electrode 40 and the electrode connection portion 41) is deposited, and the top electrode 40 and the electrode connection portion 41 are patterned by photolithography, etching, or stripping processes to form the structure shown in FIG. 8.

FIG. 8A shows a schematic sectional diagram of a structure formed by depositing a conductive metal on an electrode connection portion of a bottom electrode when providing a top electrode and the electrode connection layer, as an alternative embodiment of the structure shown in FIG. 8. In the structure shown in FIG. 8A, the metal layer covers the electrode connection portion or pin of the bottom electrode such that the electrode pin of the bottom electrode is thickened to further reduce resistivity.

Finally, an air cavity is formed at a bottom of the resonator by back etching. If the isolation layer 70 is made of the material of the sacrificial layer, the sacrificial layer is further released to form an air gap structure. If the isolation layer 70 is made of silicon dioxide, hydrofluoric acid is used for wet releasing to obtain the structure of FIG. 1.

Based on FIG. 6, steps of manufacturing the resonator structure of FIG. 2 are described below.

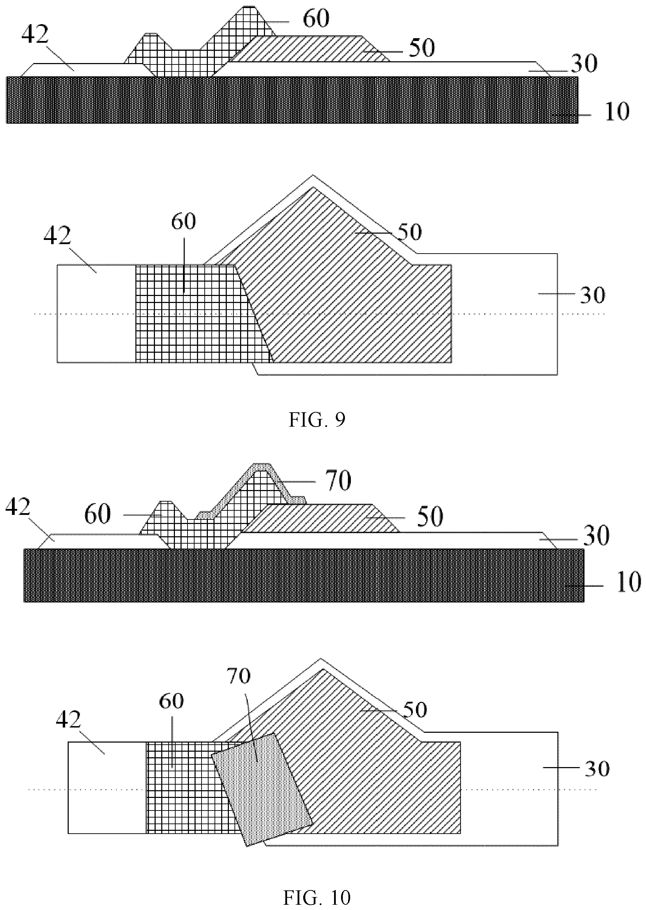

A dielectric layer 60 is deposited between the bottom electrode and the electrode pin to be an isolation layer, as shown in FIG. 9. An upper diagram of FIG. 9 is a schematic sectional diagram showing a process diagram of a method of manufacturing the bulk acoustic wave resonator in FIG. 2, and a lower diagram of FIG. 9 is a top view of the upper diagram.

Thereafter, a thin sacrificial layer 70 is deposited on the isolation layer 60, as shown in FIG. 10. An upper diagram of FIG. 10 is a schematic sectional diagram showing a process diagram of a method of manufacturing the bulk acoustic wave resonator in FIG. 2, and a lower diagram of FIG. 10 is a top view of the upper diagram.

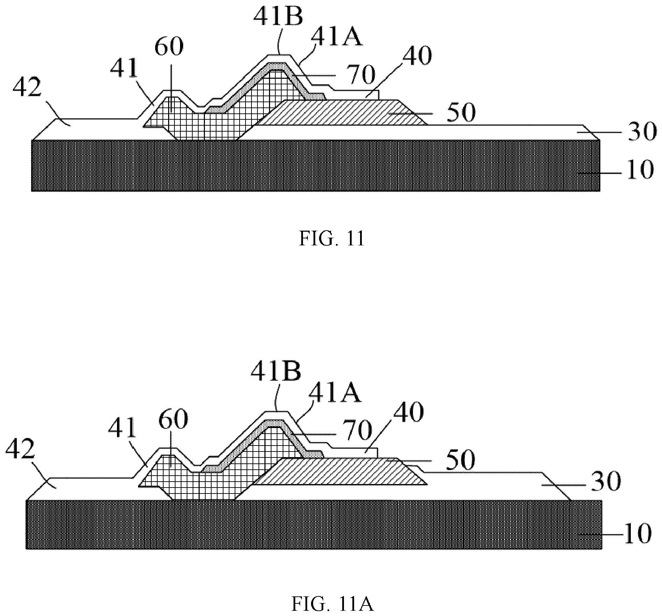

Then, a top electrode metal layer 40 and an electrode connection portion layer 41 are deposited, and the top electrode and the electrode connection portion are patterned by photolithography, etching, or stripping processes to form the structure shown in FIG. 11. FIG. 11A shows a schematic sectional diagram of a structure formed by depositing a conductive metal on an electrode connection portion of a bottom electrode when providing a top electrode and the electrode connection layer, as an alternative embodiment of the structure shown in FIG. 11. In the structure of FIG. 11A, the electrode pin of the bottom electrode is thickened, which can further reduce resistivity.

Finally, an air cavity is formed at the bottom of the resonator by back etching, and the sacrificial layer 70 is further released to form an air gap structure to obtain the structure shown in FIG. 2.

Based on FIG. 6, steps of manufacturing the resonator structure of FIG. 3 are described below.

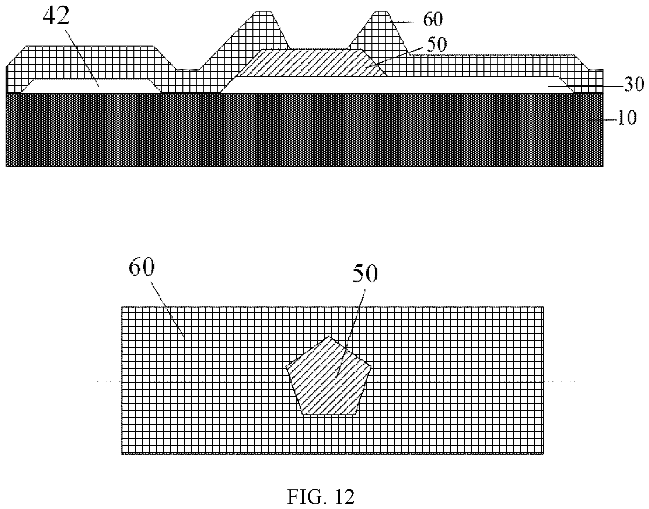

The isolation layer 60 is deposited on a surface, and the isolation layer is patterned by an etching or stripping process to expose only an effective region of the device, as shown in FIG. 12. An upper diagram of FIG. 12 is a schematic sectional diagram showing a process diagram of a method of manufacturing the bulk acoustic wave resonator in FIG. 3, and a lower diagram of FIG. 12 is a top view of the upper diagram.

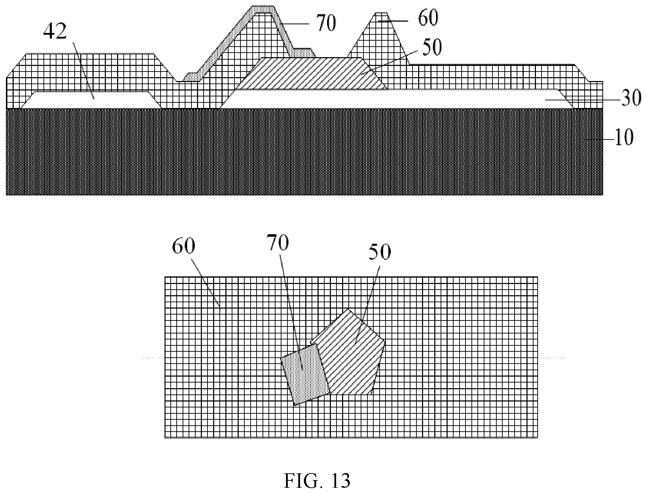

A thin sacrificial layer 70 is grown between the active region and the electrode pins of the top electrode on the isolation layer 60, as shown in FIG. 13. An upper diagram of FIG. 13 is a schematic sectional diagram showing a process diagram of a method of manufacturing the bulk acoustic wave resonator of FIG. 3, and a lower diagram of FIG. 13 is a top view of the upper diagram.

Thereafter, the patterned top electrode 40 and electrode connection portion 41 are obtained by a process such as metal sputtering, photolithography etching, or stripping, and then the isolation layer 60 arranged above the electrode pin 42 is etched, and a metal layer with good conductivity is deposited or sputtered to connect the top electrode 40 with the top electrode pin 42. Finally, an air cavity is formed at the bottom of the resonator by back etching, and the sacrificial layer 70 is further released to form an air gap structure to obtain the structure shown in FIG. 3.

In the present disclosure, the "inner side" refers to a side close to the center of the resonator in the lateral direction of the resonator, and the "outer side" refers to a side away from the center of the resonator in the lateral direction of the resonator. A direction toward the inner side or an inward direction is a direction toward the center of the resonator, and a direction toward the outer side or an outward direction is a direction away from the center of the resonator.

As can be understood by those skilled in the art, the bulk acoustic wave resonator according to the present disclosure can be configured to form a filter.

In view of the above, the present disclosure provides following technical solutions.
1. A bulk acoustic wave resonator includes:
   a substrate;
   a bottom electrode;
   a top electrode;
   a piezoelectric layer provided between the bottom electrode and the top electrode; and
   an acoustic mirror,
   wherein
   the resonator further includes an electrode connecting portion, an electrical isolation layer, and an electrode pin;
   the electrode connection portion covers the electrical isolation layer, one end of the electrode connection portion is electrically connected to the top electrode, and the other end of the electrode connection portion is configured to be electrically connected to the electrode pin;
   a part of the electrical isolation layer forms electrical isolation between the electrode connection portion and the bottom electrode of the resonator; and
   at least one portion of the electrical isolation layer covers at least part of an end face of the piezoelectric layer and an end face of the bottom electrode to form electrical isolation between the electrode connection portion and the bottom electrode.
2. The resonator according to 1, wherein
   the electrode connection portion has a thickness that is the same as a thickness of the top electrode.
3. The resonator according to 1, wherein
   the end face of the piezoelectric layer and the end face of the bottom electrode form a coplanar inclined surface.
4. The resonator according to 3, wherein
   an angle is formed between the inclined surface and a top surface of the substrate, and is in a range of 10 to 85 degrees.
5. The resonator according to 4, wherein
   the angle between the inclined surface and the top surface of the substrate is in a range of 15 to 75 degrees.
6. The resonator according to 1, wherein
   the electrical isolation layer further covers a part of a top surface of the piezoelectric layer and the end face of the piezoelectric layer; or
   the electrical isolation layer includes an end covering the top surface of the piezoelectric layer, and the end of the electrical isolation layer is located at an inner side of an edge of the acoustic mirror.
7. The resonator according to 6, wherein
   the electrode connection portion includes an inclined section connected with the top electrode and a horizontal section connected with the inclined section.
8. The resonator according to any one of 1 to 7, wherein
   the at least one portion of the electrical isolation layer forms electrical isolation between the electrode pin and the bottom electrode in a lateral direction of the resonator.
9. The resonator according to 8, wherein
   the electrode pin and the bottom electrode are arranged in a same layer; and
   a space of the same layer formed between the electrode pin and the bottom electrode in the lateral direction is filled by a part of the electrical isolation layer.
10. The resonator according to 9, wherein
   the electrical isolation layer covers a part of a top surface of the electrode pin.
11. The resonator according to 6, wherein
   the electrical isolation layer covers a part of a top surface of the electrode pin; and
   a portion of the electrical isolation layer arranged between the electrode pin and the bottom electrode has a concave shape relative to a portion of the electrical isolation layer covering a top surface of the top electrode and the top surface of the electrode pin.
12. The resonator according to 11, wherein
   the electrode connection portion has a thickness that is the same as a thickness of the top electrode; and
   in a thickness direction of the resonator, a part of the electrical isolation layer is provided at a side of the electrode pin and arranged between the electrode connection portion and the electrode pin.
13. The resonator according to any one of 1 to 12, wherein
   the resonator further includes an additional electrical isolation layer that covers the electrode pin and/or a part of the bottom electrode beyond an effective region of the resonator;
   the resonator further includes at least one conductive through hole, and the at least one conductive through hole passes through the additional electrical isolation layer to be electrically connected to a corresponding electrode pin or the bottom electrode; and
   wherein if the additional electrical isolation layer covers the electrode pin, the electrode connection portion is electrically connected to the electrode pin through the at least one electrical through hole passing through the additional electrical isolation layer.
14. The resonator according to any one of 1 to 13, wherein
   the electrical isolation layer is a non-conductive dielectric monolayer or a gap monolayer; or
   the electrical isolation layer includes a non-conductive dielectric layer and a gap layer, and at least part of the gap layer is arranged between the electrode connection portion and the non-conductive dielectric layer in a thickness direction of the resonator; or
   the electrical isolation layer includes two different non-conductive dielectric layers.
15. The resonator according to 14, wherein
   a part of the gap layer covers a portion of a top surface of the piezoelectric layer; or
   a part of the gap layer and a part of the non-conductive dielectric layer both cover the portion of the top surface of the piezoelectric layer.
16. The resonator according to any one of 1 to 15, wherein
   the piezoelectric layer is a monocrystal piezoelectric film.
17. A method of manufacturing a bulk acoustic wave resonator is provided, wherein the bulk acoustic wave resonator includes a substrate, a bottom electrode, a top electrode, a piezoelectric layer provided between the bottom electrode and the top electrode, and an acoustic mirror, the method includes:
   providing a bottom electrode layer covering the substrate and a piezoelectric film layer covering the bottom electrode on the substrate;
   patterning the bottom electrode and the piezoelectric layer, that is, etching and patterning the bottom electrode layer and the piezoelectric film layer, to form the bottom electrode and the piezoelectric layer of the resonator;
   providing an electrical isolation layer, the electrical isolation layer covering at least part of an end face of the piezoelectric layer and an end face of the bottom electrode; and
   depositing a conductive metal layer, the conductive metal layer covering the electrical isolation layer and a part of a top surface of the piezoelectric layer to form the top electrode and an electrode connecting portion, the electrode connection portion being electrically connected to the top electrode, and the electrical isolation layer providing an electrical isolation space between the electrode connection portion and the bottom electrode.
18. The method according to 17, wherein
   the method further includes releasing the electrical isolation layer; or
   in the providing the electrical isolation layer, a non-conductive dielectric layer and a sacrificial layer are provided sequentially, the sacrificial layer covers at least part of the non-conductive dielectric layer, and the method further includes releasing the sacrificial layer to form a gap layer between the electrode connection portion and the non-conductive dielectric layer in a thickness direction of the resonator.
19. The method according to 17, wherein
   in the patterning the bottom electrode and the piezoelectric layer, the end face of the piezoelectric layer and the end face of the bottom electrode form a coplanar inclined surface, and an angle is formed between the inclined surface and a top surface of the substrate and is in a range of 10 to 85 degrees.
20. The method according to 17, wherein
   in the providing the electrical isolation layer, the electrical isolation layer covers the end face of the piezoelectric layer and a part of the top surface of the piezoelectric layer.
21. The method according to 20, wherein
   in the providing the electrical isolation layer, a portion of the electrical isolation layer covering the piezoelectric layer has an inclined surface and a horizontal surface connected with the inclined surface; and
   in the depositing the conductive metal layer, the electrode connection portion covers the inclined surface and the horizontal surface to form a bridge structure of the top electrode.
22. The method according to any one of 17 to 21, wherein
   in the patterning the bottom electrode and the piezoelectric layer, a separated component is formed and separated from the bottom electrode and the piezoelectric layer;
   the method further includes removing a piezoelectric layer portion of the separated component to expose a bottom electrode portion, and the bottom electrode portion is used as the electrode pin; and
   in the depositing the conductive metal layer, the conductive metal layer covers the electrical isolation layer, the electrode pin, and a part of the top surface of the piezoelectric layer.
23. The method according to 22, wherein
   in the providing the electrical isolation layer, one side of the electrical isolation layer covers a part of the top surface of the electrode pin, another side of the electrical isolation layer covers a part of the top surface of the piezoelectric layer, and a part of the electrical isolation layer arranged between the electrode pin and the top electrode in a lateral direction has a recessed portion.
24. The method according to 22, wherein
   in the providing the electrical isolation layer, the electrical isolation layer covers the electrode pin or covers the electrode pin and a part of the bottom electrode beyond an effective region; and
   the method further includes providing a conductive through hole electrically connected to the electrode pin; and
   the providing the conductive through hole further includes electrically connecting the electrode connection portion and the conductive through hole.
25. A filter includes the bulk acoustic wave resonator according to any one of 1 to 16.
26. An electronic device includes the filter according to 25 or the bulk acoustic wave resonator according to any one of 1 to 16.

The electronic device herein includes, but is not limited to, intermediate products such as an RF front end, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
a bottom electrode;
a top electrode;
a piezoelectric layer provided between the bottom electrode and the top electrode;
an acoustic mirror;
an electrode connecting portion covering the electrical isolation layer;
an electrical isolation layer; and
an electrode pin,
wherein one end of the electrode connection portion is electrically connected to the top electrode, and another end of the electrode connection portion is configured to be electrically connected to the electrode pin;
wherein a part of the electrical isolation layer forms electrical isolation between the electrode connection portion and the bottom electrode of the resonator; and
wherein at least one portion of the electrical isolation layer covers at least part of an end face of the piezoelectric layer and an end face of the bottom electrode to form electrical isolation between the electrode connection portion and the bottom electrode.

2. The resonator according to claim 1, wherein the electrode connection portion has a thickness that is the same as a thickness of the top electrode.

3. The resonator according to claim 1, wherein the end face of the piezoelectric layer and the end face of the bottom electrode form a coplanar inclined surface.

4. The resonator according to claim 3, wherein an angle is formed between the inclined surface and a top surface of the substrate, and is in a range of 10 to 85 degrees.

5. The resonator according to claim 4, wherein the angle between the inclined surface and the top surface of the substrate is in a range of 15 to 75 degrees.

6. The resonator according to claim 1, wherein the electrical isolation layer further covers a part of a top surface of the piezoelectric layer and the end face of the piezoelectric layer; or
the electrical isolation layer comprises an end covering the top surface of the piezoelectric layer, and the end of the electrical isolation layer is located at an inner side of an edge of the acoustic mirror.

7. The resonator according to claim 6, wherein the electrode connection portion comprises an inclined section connected with the top electrode and a horizontal section connected with the inclined section.

8. The resonator according to any one of claims 1 to 7, wherein the at least one portion of the electrical isolation layer forms electrical isolation between the electrode pin and the bottom electrode in a lateral direction of the resonator.

9. The resonator according to claim 8, wherein the electrode pin and the bottom electrode are arranged in a same layer; and
a space of the same layer formed between the electrode pin and the bottom electrode in the lateral direction is filled by a part of the electrical isolation layer.

10. The resonator according to claim 9, wherein the electrical isolation layer covers a part of a top surface of the electrode pin.

11. The resonator according to claim 6, wherein the electrical isolation layer covers a part of a top surface of the electrode pin; and
a portion of the electrical isolation layer arranged between the electrode pin and the bottom electrode has a concave shape relative to a portion of the electrical isolation layer covering a top surface of the top electrode and the top surface of the electrode pin.

12. The resonator according to claim 11, wherein the electrode connection portion has a thickness that is the same as a thickness of the top electrode; and
in a thickness direction of the resonator, a part of the electrical isolation layer is provided at a side of the electrode pin and arranged between the electrode connection portion and the electrode pin.

13. The resonator according to any one of claims 1 to 12, further comprising:
an additional electrical isolation layer covering the electrode pin and/or a part of the bottom electrode beyond an effective region of the resonator; and
at least one conductive through hole passing through the additional electrical isolation layer and being electrically connected to a corresponding electrode pin or the bottom electrode,
wherein if the additional electrical isolation layer covers the electrode pin, the electrode connection portion is electrically connected to the electrode pin through the at least one electrical through hole passing through the additional electrical isolation layer.

14. The resonator according to any one of claims 1 to 13, wherein the electrical isolation layer is a non-conductive dielectric monolayer or a gap monolayer; or
the electrical isolation layer comprises a non-conductive dielectric layer and a gap layer, and at least part of the gap layer is arranged between the electrode connection portion and the non-conductive dielectric layer in a thickness direction of the resonator; or
the electrical isolation layer comprises two different non-conductive dielectric layers.

15. The resonator according to claim 14, wherein a part of the gap layer covers a portion of a top surface of the piezoelectric layer; or
a part of the gap layer and a part of the non-conductive dielectric layer both cover the portion of the top surface of the piezoelectric layer.

16. The resonator according to any one of claims 1 to 15, wherein the piezoelectric layer is a monocrystal piezoelectric film.

17. A method of manufacturing a bulk acoustic wave resonator, wherein the bulk acoustic wave resonator comprises a substrate, a bottom electrode, a top electrode, a piezoelectric layer provided between the bottom electrode and the top electrode, and an acoustic mirror, the method comprises:
providing a bottom electrode layer covering the substrate and a piezoelectric film layer covering the bottom electrode on the substrate;
patterning the bottom electrode and the piezoelectric layer, that is, etching and patterning the bottom electrode layer and the piezoelectric film layer, to form the bottom electrode and the piezoelectric layer of the resonator;
providing an electrical isolation layer, the electrical isolation layer covering at least part of an end face of the piezoelectric layer and an end face of the bottom electrode; and
depositing a conductive metal layer, the conductive metal layer covering the electrical isolation layer and a part of a top surface of the piezoelectric layer to form the top electrode and an electrode connecting portion, the electrode connection portion being electrically connected to the top electrode, and the electrical isolation layer providing an electrical isolation space between the electrode connection portion and the bottom electrode.

18. The method according to claim 17, wherein the method further comprises releasing the electrical isolation layer; or
in the providing the electrical isolation layer, a non-conductive dielectric layer and a sacrificial layer are provided sequentially, the sacrificial layer covers at least part of the non-conductive dielectric layer, and the method further comprises releasing the sacrificial layer to form a gap layer between the electrode connection portion and the non-conductive dielectric layer in a thickness direction of the resonator.

19. The method according to claim 17, wherein in the patterning the bottom electrode and the piezoelectric layer, the end face of the piezoelectric layer and the end face of the bottom electrode form a coplanar inclined surface, and an angle is formed between the inclined surface and a top surface of the substrate and is in a range of 10 to 85 degrees.

20. The method according to claim 17, wherein in the providing the electrical isolation layer, the electrical isolation layer covers the end face of the piezoelectric layer and a part of the top surface of the piezoelectric layer.

21. The method according to claim 20, wherein in the providing the electrical isolation layer, a portion of the electrical isolation layer covering the piezoelectric layer has an inclined surface and a horizontal surface connected with the inclined surface; and
in the depositing the conductive metal layer, the electrode connection portion covers the inclined surface and the horizontal surface to form a bridge structure of the top electrode.

22. The method according to any one of claims 17 to 21, wherein in the patterning the bottom electrode and the piezoelectric layer, a separated component is formed and separated from the bottom electrode and the piezoelectric layer;
the method further comprises removing a piezoelectric layer portion of the separated component to expose a bottom electrode portion, and the bottom electrode portion is used as the electrode pin; and
in the depositing the conductive metal layer, the conductive metal layer covers the electrical isolation layer, the electrode pin, and a part of the top surface of the piezoelectric layer.

23. The method according to claim 22, wherein in the providing the electrical isolation layer, one side of the electrical isolation layer covers a part of the top surface of the electrode pin, another side of the electrical isolation layer covers a part of the top surface of the piezoelectric layer, and a part of the electrical isolation layer arranged between the electrode pin and the top electrode in a lateral direction has a recessed portion.

24. The method according to claim 22, wherein in the providing the electrical isolation layer, the electrical isolation layer covers the electrode pin or covers the electrode pin and a part of the bottom electrode beyond an effective region;
the method further comprises providing a conductive through hole electrically connected to the electrode pin; and
the providing the conductive through hole further comprises electrically connecting the electrode connection portion and the conductive through hole.

25. A filter, comprising the bulk acoustic wave resonator according to any one of claims 1 to 16.

26. An electronic device, comprising the filter according to claim 25 or the bulk acoustic wave resonator according to any one of claims 1 to 16.
